Europäisches Patentamt

European Patent Office

Office européen des brevets

(11) Numéro de publication: **0 233 674**
**A1**

(12) **DEMANDE DE BREVET EUROPEEN**

(21) Numéro de dépôt: **87200210.0**

(22) Date de dépôt: **11.02.87**

(51) Int. Cl.⁴: **H01R 23/70**

(30) Priorité: **14.02.86 FR 8602027**

(43) Date de publication de la demande:
**26.08.87 Bulletin 87/35**

(84) Etats contractants désignés:
**DE FR GB**          -

(71) Demandeur: **RTC-COMPELEC**
**130, Avenue Ledru-Rollin**
**F-75011 Paris(FR)**
**FR**
Demandeur: **N.V. Philips'**
**Gloeilampenfabrieken**
**Groenewoudseweg 1**
**NL-5621 BA Eindhoven(NL)**
**DE GB**

(72) Inventeur: **Sorel, Alain Société Civile SPID**
**209 rue de l'Université**
**F-75007 Paris(FR)**
Inventeur: **Vernet, Francis Société Civile SPID**
**209 rue de l'Université**
**F-75007 Paris(FR)**

(74) Mandataire: **Caron, Jean et al**
**SOCIETE CIVILE S.P.I.D. 209, rue de**
**l'Université**
**F-75007 Paris(FR)**

(54) **Connecteur pour bus informatique.**

(57) L'invention concerne un connecteur pour bus informatique ou autre connexion complexe en électronique rapide.

Selon l'invention le connecteur comporte une pluralité de substrats (4, 5, 6) disposés sur plusieurs étages pratiquement parallèles entre eux. Des circuits actifs (10) sont montées sur les substrats (4, 5, 6) et sont connectés entre des broches d'entrée 2 destinées à être raccordées à un connecteur extérieur et des broches (1) à souder sur une carte de circuit imprimé (28). Les broches de connecteur (2) sont droites et fixées à plat au bord des substrats (4, 5, 6) qui portent les circuits actifs (10) : l'écart entre deux substrats est donc égal à celui entre deux rangées de broches.

Les broches à souder (1) sont perpendiculaires aux broches de connecteur (2) et fixées aussi aux substrats.

FIG.2

## "CONNECTEUR POUR BUS INFORMATIQUE"

La présente invention concerne un connecteur comportant une première série de broches réparties en plusieurs rangées et destinées à être raccordées à un circuit électrique imprimé, et une deuxième série de broches également réparties en plusieurs rangées et destinées à être raccordées à un connecteur extérieur. Un tel connecteur est bien connu et se trouve au catalogue des fournisseurs de connecteurs.

Une application d'un tel connecteur est par exemple de réaliser les liaisons électriques entre une carte d'informatique complexe et un bus amené sur le connecteur, par exemple un bus dit "VME". Pour réaliser une telle liaison, il faut prévoir des circuits d'interface constitués essentiellement par des circuits intégrés qui ont par exemple pour effet de mettre en forme, de retarder ou de mémoriser provisoirement des données, d'aiguiller des données selon leur sens de transmission, c'est-à-dire d'assurer la liaison d'une ligne de données bidirectionnelle avec deux lignes unidirectionnelles, d'adapter les niveaux ou la chargeabilité ("fan-out" en anglais) des circuits de la carte. Ces circuits d'interface sont disposés sur la carte imprimée, à côté du connecteur, qui est habituellement d'un type appelé connecteur "coudé". Ces circuits d'interface sont nécessaires sur chaque carte et y occupent une place notable. Or il est nécessaire, en électronique très rapide, que les liaisons soient les plus courtes possible, et la surface occupée par l'ensemble des circuits d'interface fait que cette exigence est difficile à satisfaire. On pourrait songer à réduire la surface nécessaire en montant sur la carte des circuits intégrés sous forme de pastilles nues ou "puces". Mais cette technique n'est pas économiquement envisageable pour au moins deux raisons : d'une part le rendement de montage des pastilles nues est faible et on ne peut prendre le risque de mettre au rebut une carte entière, dont le prix est souvent très élevé, et d'autre part le format des cartes empêche leur montage sur la plupart des machines de cablage de puces.

L'invention a pour but de fournir un connecteur qui permet de gagner de la surface au niveau des circuits d'interface et d'améliorer en conséquence le prix de revient des cartes et leur performances électriques grâce à la réduction des longueurs des connexions.

A cet effet le connecteur selon l'invention, est notamment remarquable en ce qu'il comporte une pluralité de substrats disposés sur plusieurs étages pratiquement parallèles entre eux, ayant chacun un de leur côtés alignés avec le côté correspondant des autres substrats, chacun des substrats portant le long dudit côté une rangée de l'une des deux séries de broches du connecteur, des composants actifs étant montés sur les substrats, et étant connectés entre les deux séries de broches.

Pour obtenir la densité souhaitée, les substrats portent des composants montés en surface et particulièrement des semiconducteurs en pastilles montées directement sur les substrats.

Grace à la subdivision en petits substrats, l'emploi de "puces" devient économiquement viable, et cet emploi a pour conséquence une réduction des dimensions qui diminue les longueurs des liaisons et accroît donc les performances électriques. En outre cela permet l'emploi de substrats spécialisés pour certains circuits, par exemple pour ceux qui tirent avantage d'un substrat à constante diélectrique faible : la matière constituant le substrat peut éventuellement être différente d'un substrat à l'autre. Habituellement une telle subdivision a pour conséquence dommageable de multiplier aussi le nombre des liaisons intersubstrats (soudures, connecteurs) ce qui augmente les longueurs de connexion en annihilant l'avantage escompté, augmente aussi le prix et diminue la fiabilité.

Grâce aux dispositions particulières de l'invention les broches destineés à être raccordées au circuit imprimé de la carte sont utilisés pour raccorder la carte avec les substrats, et les broches destinées à être raccordées à un connecteur extérieur sont utilisées pour raccorder de la façon la plus directe ces mêmes substrats avec l'extérieur : on a donc utilisé pour connecter les substrats des broches qui sont de toute façon présentes, et le nombre de broches additionnelles spécifiquement utilisées pour la connexion des substrats et globalement réduit.

Avantageusement les broches portées par les substrats le long dudit côté aligné sont droites et sont fixées à plat le long du bord de chaque substrat.

Dans une forme de réalisation particulière où les broches d'une série sont pratiquement perpendiculaires à celles de l'autre série, c'est-à-dire que le connecteur est du type "coudé", au moins un côté autre que le susdit côté aligné des substrats est au contraire en retrait par rapport au côté correspondant d'un des substrats voisins de façon à libérer le passage pour une connexion fixée perpendiculairement en bordure du substrat voisin.

Cette particularité a pour avantage de permettre un accès électrique direct à tous les étages des circuits d'interface, toutes les broches étant placées le long des bords extérieurs de chaque substrat, et ces derniers restant ainsi mécaniquement indépendants et donc faciles à assembler dans le connecteur.

L'ensemble des circuits d'interface consómme une puissance relativement importante, et cette puissance peut être dissipée grâce au fait que les substrats sont contenus dans un boitier muni de moyens de refroidissement, ce boitier étant rempli d'une matière conduisant la chaleur.

Dans le but d'obtenir des performances encore améliorées grâce au raccourcissement des interconnexions, le connecteur comporte avantageusement des liaisons électriques directes entre deux substrats voisins.

Ceci accroît la complexité structurelle de connecteur et pourrait en rendre le montage plus difficile ; mais ce n'est pas le cas si lesdites liaisons sont réalisés au moyen d'une pluralité de conducteurs, chacun étant fixé à un seul de deux substrats voisins et appuyé sur un élément conducteur de l'autre substrat ou si lesdites liaisons sont réalisés au moyens de conducteurs élastiques portés par une barrette isolante, et pressés entre deux substrats voisins.

La description qui va suivre, en regard des dessins annexés decrivant des exemples non limitatifs fera bien comprendre comment l'invention peut être réalisée.

La figure 1 est une vue en perspective d'un connecteur selon l'invention.

La figure 2 est une coupe suivant B du connecteur de la figure 1.

La figure 3 est une coupe suivant A du connecteur de la figure 2.

La figure 4 représente la disposition des broches de l'une des séries.

La figure 5 représente un mode de réalisation de connexions directes entre substrats voisins.

La figure 6 représente un autre mode de réalisation de connexions directes entre substrats voisins.

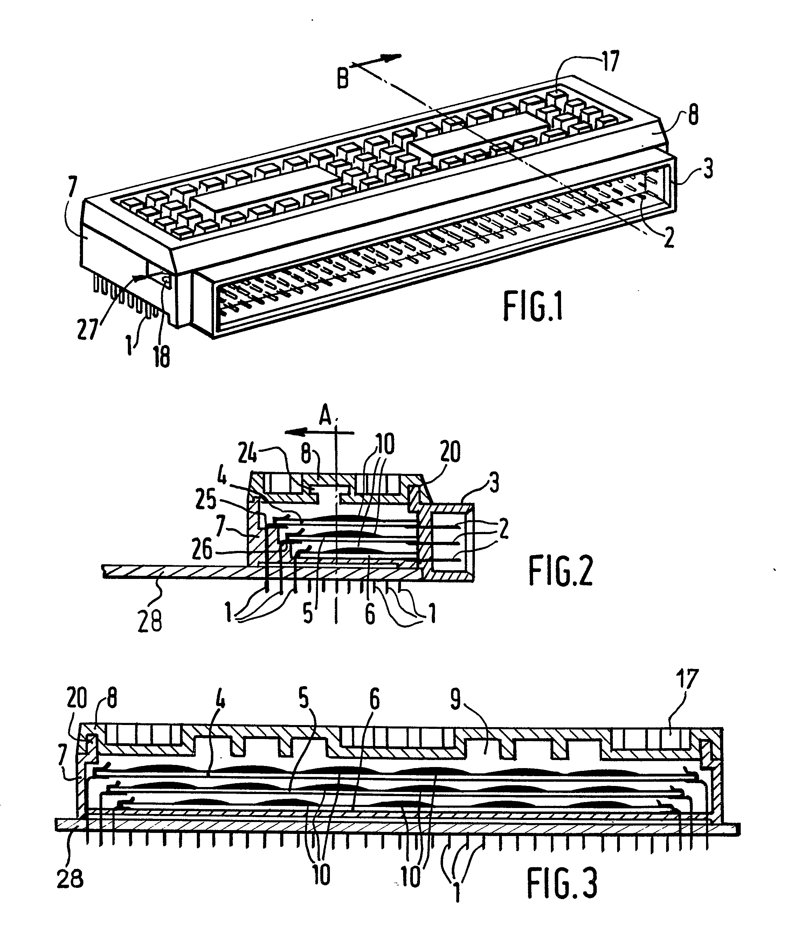

Le connecteur de la figure 1 a sensiblement la même hauteur, mais est un peu plus profond qu'un connecteur coudé passif. Il comporte une première série de broches 1 disposées verticalement sous sa face inférieure et destinées a être raccordées à un circuit électrique imprimé, et une deuxième série de broches 2 horizontales placées sur la face avant du connecteur est destinées à être raccordées à un connecteur extérieur (non représenté). La figure 2 est une coupetransversale selon B et montre à l'intérieur de connecteur un ensemble de circuits actifs 10 connectés entre la première série de broches 1 et la seconde série de broches 2 et qui sont réalisées sur trois substrats 4, 5, 6 disposés sur trois étages pratiquement parallèles entre eux.

Ces trois substrats ont un de leurs cotés aligné avec le coté correspondant des deux autres, c'est-à-dire qu'ils sont tous dans la position représentée ici sur la figure, fictivement appuyés à droite sur un même plan vertical virtuel perpendiculaire au plan de la figure et aux plans des substrats, et chaque substrat porte le long dudit coté une des rangées de la deuxième série de broches 2. Ces broches sont droites et soudées à plat le long du bord droit (sur la figure) de chacun des substrats 4, 5, 6. L'entraxe vertical des substrats est donc égal à l'entraxe normalisé des rangées de broches 2.

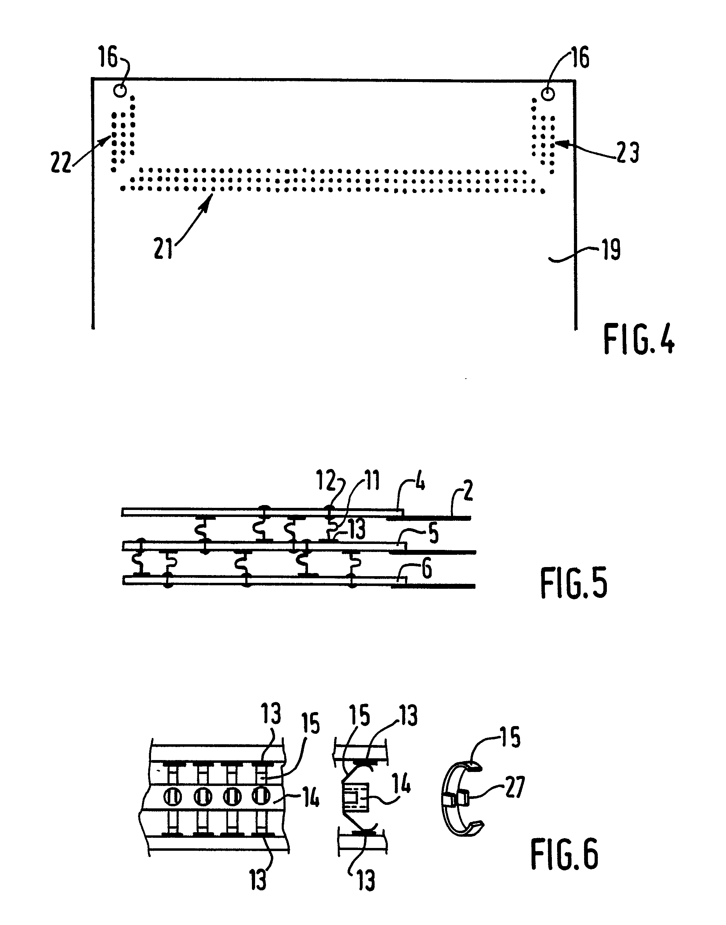

Dans ce connecteur les broches 1 de la première série sont pratiquement perpendiculaires à celles de la deuxième série et le substrat 5 a une largeur inférieur à celle du substrat 4 de manière à permettre le passage des connexions 25 reliées au substrat 4 à gauche (sur la figure) de l'extrémité gauche du substrat 5. De la même manière le substrat 6 est moins large que le substrat 5 pour permettre le passage des connexions 26 reliées à ce dernier. Ces connexions verticales reliées à des substrats horizontaux sont d'un type classique dans la technique dite de circuits "hybrides". Les substrats sont réalisés par exemple en verre epoxy et choisis d'une épaisseur appropriée pour les connexions standards 25, 26. La figure 3 qui est une coupe dans la direction perpendiculaire à celle de la figure 2 montre que dans l'autre dimension les substrats ont également une taille décroissante du haut vers le bas pour permettre le montage de connexions à leurs deux extrémités. Dans l'exemple illustré ici la deuxième série comprend 96 broches réparties en trois rangées de 32 broches espacées de 2,54 mm. La disposition des broches de la première série est indiquée par la figure 4 qui montre l'extrémité d'une carte destinée à recevoir un connecteur suivant l'invention. Ces broches sont disposées en trois ensembles 21, 22, 23 de chacun 3 rangées de broches au pas de 1.905 mm. La disposition représentée comport 175 broches.

Chacun des substrat supporte plusieurs circuits intégrés utilisés sous forme de pastille. Tous ces circuits sont collés sur les substrats et cablés au moyen de fils de préférence sur une machine automatique. Ils sont protégés avant l'assemblage des substrats par le dépôt d'une goutte de vernis. Ces circuits protégés sont indiqués par la référence 10 sur les figures 2 et 3. La complexité des circuits nécessaire pour relier un si grand nombre de broches de connexion aux nombreuses sorties des circuits intégrés nécessite en général l'utilisation de circuits multicouches pour les substrats, ou au moins à double face et à trous métallisés. Au lieu de substrats époxy on peut aussi utiliser des substrats en céramique du type employé dans la technologie "hybride", avec plusieurs niveaux de métallisations en surface.

Avec la disposition présentée, la liaison d'un point situé par exemple sur le substrat 4 à un point situé sur le substrat 5 nécessite le passage par l'intermédiaire d'une connexion 25, d'une métallisation sur le circuit imprimé de base 28 et d'une connexion 26. Cette sujétion accroît encore la complexité des circuits, c'est pourquoi il peut être avantageux d'utiliser des liaisons électriques directes entre deux substrats voisins. De telles liaisons peuvent être faites au moyen de broches rigides verticales soudées à leurs extrémités sur chacun des deux circuits à relier. Toutefois de telles liaisons rendent l'ensemble du circuit délicat à monter et pratiquement impossible à démonter.

Les liaisons représentées par la figure 5 évitent cet inconvénient. Elles sont constituées par une troisième série de broches 11 qui sont placées entre deux substrats voisins 4, 5 ou bien 5, 6, et sont fixées à un seul des deux substrats qu'elles relient. La connexion représentée en 11 est soudée en 12 sur le substrat 4 et assure un contact par pression contre la plage 13 de circuit 5. Bien entendu l'inverse est possible et la figure 5 comporte également des broches fixées au circuit 5 et assurant un contact par pression sur une plage du circuit 4, et de même pour les liaisons entre les substrats 5 et 6. Les liaisons représentées comportent une partie en forme de U destiné à assurer un effet de ressort. Tout moyen connu pour assurer un contact par pression peut évidemment être employé. La figure 6 présente un autre mode de réalisation de ces liaisons verticales dans lesquelles elles sont réalisées au moyen de lamelles élastiques 15 essentiellement perpendiculaires aux substrats et portés par une barrette isolante 14. Ces lamelles prennent contact avec des métallisations 13 sur les substrats. Lors du découpage de ces lamelles des ergots 27 sont pliés de manière à permettre une fixation par enfoncement dans des trous de la barrette 14. Les barrettes sont fixées mécaniquement par tout moyen connu à un boitier qui supporte l'ensemble des substrats.

Un boitier est constitué de plusieurs parties 7, 8, 3 réalisées en matière plastique. La partie 7 - (figures 2 et 3) constitue une boite ouverte sur un des grands côtés latéraux et sur le dessus. Cette boite et avantageusement munie de ressauts en forme de marches d'escaliers, visibles sur la figure 2 au niveau des connexions 25, 26, et qui supportent les substrats de dimensions décroissantes du haut vers le bas. Le grand côté latéral est fermé par la pièce 3 qui supporte et encadre les broches de la deuxième série et le dessus est fermé par un couvercle 8 en métal moulé. Ce couvercle 8 est muni de reliefs 17 destinés à en augmenter la surface et à améliorer le refroidissement. Pour assurer un meilleur contact thermique entre les substrats et leurs circuits intégrés et le couvercle 8 le boitier est avantageusement rempli d'une matière plastique bonne conductrice de la chaleur 9. Ce remplissage est avantageusement effectué après la mise en place du couvercle 8 sur le boitier 7 en injectant la matière par le trou 27 (figure 1), l'ensemble étant disposé la tête en bas. L'entourage du boitier 7 et la pièce 3 sont munis de languettes 20 coopérant avec des rainures du couvercle 8 pour assurer une meilleure étanchéité lors du remplissage. Le couvercle 8 est munis de trous en forme de mortaises 24 pour assurer son accrochage avec la matière plastique de remplissage. Cette dernière est par exemple une résine connue sous le nom commercial SILITRO, résine C 10 à deux composantes polymérisant à froid. Les parties 7 et 3 du boitier peuvent être réalisées dans un matériau connu sous le nom commercial RYNITE FR530 de chez DUPONT DE NEMOURS. Le métal du couvercle 8 est par exemple de l'aluminium.

L'ensemble peut être fixé sur le circuit imprimé 28 au moyen de la première série de broches 1, et cette fixation est avantageusement complétée par des vis traversant les trous 16 (figure 4) du circuit imprimé de base 28 et vissées dans les trous 18 (figure 1) du connecteur.

Il est bien évident que la réalisation du connecteur selon l'invention n'est pas limitée à l'exemple décrit ici et qu'en particulier le nombre de broches, le nombre de rangées des broches de chaque série et en conséquence le nombre de substrats peuvent être différents. Dans le cas ou des interconnexions directes sont utilisées, la disposition des broches de la première série en périphérie n'est pas indispensable.

## Revendications

1-Connecteur comportant une première série de broches réparties en plusieurs rangées et destinées à être raccordées à un circuit électrique imprimé, et une deuxième série de broches également réparties en plusieurs rangées et destinées à être raccordées à un connecteur extérieur, caractérisé en ce qu'il comporte une pluralité de substrats disposés sur plusieurs étages pratiquement parallèles entre eux, ayant chacun un de leur côtés alignés avec le côté correspondant des autres substrats chacun des substrats portant le long dudit côté une rangée de l'une des deux séries de broches du connecteur, des composants actifs étant montés sur les substrats et étant connectés entre les deux séries de broches.

2-Connecteur selon la revendication 1, caractérisée en ce que les broches portées par les substrats le long dudit côté aligné sont droites et sont fixées à plat le long du bord de chaque substrat.

3-Connecteur selon l'une des revendications 1 ou 2, dans lequel les broches d'une des séries sont pratiquement perpendiculaires à celles de l'autre série, caractérisé en ce qu'au moins un côté autre que le susdit côté aligné des substrats est au contraire en retrait par rapport au côté correspondant d'un des substrats voisins de façon à libérer le passage pour une connexion fixée perpendiculairement en bordure du substrat voisin.

4-Connecteur selon l'une quelconque des revendications précédentes, caractérisé en ce que les substrats sont contenus dans un boitier muni de moyens de refroidissement, ce boitier étant rempli d'une matière conduisant la chaleur.

5-Connecteur selon l'une quelconque des revendications précédentes, caractérisé en ce que les substrats portent des composants montés en surface et particulièrement des semiconduc teurs en pastilles montées directement sur les substrats.

6-Connecteur selon l'une quelconque des revendications précédentes caractérisé en ce qu'il comporte des liaisons électriques directes entre deux substrats voisins.

7-Connecteur selon la revendication 6, caractérisé en ce que lesdites liaisons sont réalisés au moyens d'une pluralité de conducteurs, chacun étant fixé à un seul de deux substrats voisins et appuyé sur un élément conducteur de l'autre substrat.

8-Connecteur selon la revendication 6, caractérisé en ce que lesdites liaisons sont réalisés au moyens de conducteurs élastiques portés par une barrette isolante, et pressés entre deux substrats voisins.

FIG.1

FIG.2

FIG.3

FIG.4

FIG.5

FIG.6

## DOCUMENTS CONSIDERES COMME PERTINENTS

| Categorie | Citation du document avec indication. en cas de besoin. des parties pertinentes | Revendication concernee | CLASSEMENT DE LA DEMANDE (Int Cl 4) |
|---|---|---|---|
| Y | US-A-4 520 429  (HOSKING)<br>* Résumé; colonne 3, ligne 40 - colonne 5, ligne 35; figures 1-4 * | 1 | H 01 R  23/70 |
| A |  | 3 | |
| Y | FR-A-1 344 202  (LA TELEMECANIQUE ELECTRIQUE)<br>* Page 4, colonne de gauche, paragraphes 4,5; figure 7 * | 1 | |
| A |  | 2,4,6 | |
| A | FR-A-2 114 169  (HONEYWELL)<br>* En entier * | 1 | |

DOMAINES TECHNIQUES
RECHERCHES (Int. Cl 4)

H 01 R   9/00
H 01 R  23/00
H 01 R  13/00
H 01 R  29/00
H 05 K   1/00
H 05 K   7/00

Le présent rapport de recherche a été établi pour toutes les revendications

| Lieu de la recherche | Date d'achevement de la recherche | Examinateur |
|---|---|---|
| LA HAYE | 21-05-1987 | RIEUTORT A.S. |